# EUROPÄISCHE PATENTSCHRIFT

(11) **EP 1 329 144 B1**
(45) Veröffentlichungstag und Bekanntmachung des Hinweises auf die Patenterteilung: **02.06.2004**
(21) Anmeldenummer: 01988009.5
(22) Anmeldetag: 16.10.2001
(51) Int. Cl.: H05K 3/34, H05K 1/11, H05K 7/08

(54) **BAUGRUPPENTRÄGER FÜR ELEKTRISCHE/ELEKTRONISCHE BAUELEMENTE**
MODULE SUPPORT FOR ELECTRICAL/ELECTRONIC COMPONENTS
SUPPORT MODULAIRE POUR COMPOSANTS ELECTRIQUES/ELECTRONIQUES

(30) Priorität: 18.10.2000 DE 10051547
(43) Veröffentlichungstag der Anmeldung: 23.07.2003
(73) Patentinhaber: ROBERT BOSCH GMBH, 70442 Stuttgart (DE)
(72) Erfinder: SCHMID, Roland, 70599 Stuttgart (DE); UHLAND, Thomas, 74397 Pfaffenhofen-Weiler (DE); BECKBISSINGER, Kai, 70569 Stuttgart (DE); SCHINZEL, Ralf, 71672 Marbach am Neckar (DE); HENNEL, Udo, 03150 Victoria Glen Waverley (AU)
(74) Vertreter: Burbaum, Christoph
(86) Internationale Anmeldenummer: PCT/DE2001/003953
(87) Internationale Veröffentlichungsnummer: WO 2002/034022

(56) Entgegenhaltungen:
- WO-A-00/51141
- US-A- 3 216 089
- US-A- 3 978 375
- US-A- 5 451 720
- PATENT ABSTRACTS OF JAPAN vol. 1999, no. 08, 30. Juni 1999 (1999-06-30) -& JP 11 068289 A (MATSUSHITA ELECTRIC IND CO LTD), 9. März 1999 (1999-03-09)

## Beschreibung

### Stand der Technik

Die Erfindung betrifft einen Baugruppenträger für elektrische/elektronische Bauelemente nach dem Oberbegriff des Anspruchs 1.

Ein derartiger Baugruppenträger ist beispielsweise aus der WO-A-0 051 141 oder der DE 296 22 806 U1 bekannt und umfaßt eine aus einem Stanzgitter gebildete Leiterstruktur aus mehreren metallischen Leitern, die in eine Isolierstoffumhüllung eingebracht sind. Üblicher Weise wird die Leiterstruktur aus einem Metallblech ausgestanzt und anschließend in einem Spritzgußverfahren mit Kunststoff umspritzt. Die einzelnen Leiter können nach dem Stanzen zunächst über dünne Stege verbunden bleiben, die dann vor oder, durch dafür vorgesehene Aussparungen in der Umhüllung, auch noch nach dem Umspritzen mit Kunststoff getrennt werden können. Derartige Baugruppenträger werden beispielsweise verwendet, um große schwere elektrische Bauelemente oder mit hohen Stromstärken arbeitende Bauelemente untereinander und mit anderen elektrischen Bauelementen zu verbinden. Zu diesem Zweck sind Kontaktbereiche des Baugruppenträgers vorgesehen, die jeweils einen durch Ausnehmungen in der Isolierstoffumhüllung frei zugänglichen Kontaktabschnitt eines elektrischen Leiters umfassen. Die Anschlußelemente der elektrischen oder elektronischen Bauelemente werden mit den Kontaktabschnitten verlötet, verschweißt oder mittels Klemmkontaktierung elektrisch verbunden. Beim Verlöten der Anschlußelemente werden die Kontaktabschnitte stark erwärmt. Nachteilig bei den bekannten Baugruppenträgern mit Stanzgitter ist, daß die dabei von den Kontaktabschnitten direkt auf die von der Isolierstoffumhüllung umaebenen Abschnitte der metallischen Leiter übertragene Wärme die Isolierstoffumhüllung des Baugruppenträgers beschädigen kann.

### Vorteile der Erfindung

Durch den erfindungsgemäßen Baugruppenträger mit den kennzeichnenden Merkmalen des Anspruchs 1 werden die im Stand der Technik bekannten Nachteile vermieden und erreicht, daß die insbesondere beim Löten auf die Kontaktabschnitte übertragene Wärme nicht ungehindert auf die mit der Isolierstoffumhüllung umgebenen Teile der Leiterstruktur abfließen kann. Durch die spezielle Ausgestaltung der elektrischen Leiter in den durchgehenden Ausnehmungen des Baugruppenträgers kann die Wärme nur über Verbindungsstege mit einen kleinen Wärmeleitungsquerschnitt abfließen. Die Verbindungsstege drosseln den Wärmeabfluß auf die mit der Isolierstoffumhüllung umgebenen Abschnitte des Stanzgitters. Eine Beschädigung des Baugruppenträgers bei einer starken Erwärmung der Kontaktabschnitte der metallischen Leiter kann dadurch vorteilhaft verhindert werden. Weiterhin wird insbesondere beim Verlöten der Anschlußelemente eines Bauelementes mit den Kontaktabschnitten des Leitungsgitters erreicht, daß die für das Löten benötigte Prozeßwärme an der Lötstelle verbleibt. Vorteilhaft kann deshalb mit kleinen Löttiegeln oder Lötstempeln eine Selektivlötung der einzelnen Lötstellen vorgenommen werden, was zur einer deutlichen Verbesserung der Lötqualität führt. Die Anschlußelemente elektronischer Bauelemente können vorteilhaft in einem Prozeßschritt mit den Kontaktabschnitten verlötet werden. Die konstruktive Ausgestaltung der Kontaktbereiche des Baugruppenträgers ist in sehr einfacher und preiswerter Weise ohne großen Mehraufwand herstellbar.

Vorteilhafte Ausführungsbeispiele und Weiterbildungen der Erfindung werden durch die in den Unteransprüchen enthaltenen Merkmale ermöglicht.

Vorteilhaft ist, wenn die Kontaktabschnitte der Leiterstruktur in Form von Lötaugen mit einer zentralen Öffnung zur Durchführung jeweils eines Anschlußelementes eines elektrischen/elektronischen Bauelementes ausgebildet sind. Diese Maßnahme ermöglicht es, das Bauelement in einer zur Leiterplattenfertigung analogen Vorgehensweise auf den Baugruppenträger zu bestücken, wobei die Anschlußelemente eines Bauelementes in die Öffnungen der Lötaugen eingesteckt und anschließend verlötet werden können.

Erfindungsgemäß ist der wenigstens eine Verbindungssteg, über den der Kontaktabschnitt mit der Leiterstruktur verbunden ist, aus der Ebene der Leiterstruktur derart abgebogen, daß der Kontaktabschnitt in einer zur Ebene der Leiterstruktur parallelen Ebene innerhalb oder außerhalb der Ausnehmung angeordnet ist. Hierdurch wird eine starke Erleichterung beim Verlöten der Anschlußelemente eines Bauelementes erreicht. Durch die Biegung des Verbindungssteges kann insbesondere beim selektiven Löten mit einem Lottiegel ein vollständiges Eintauchen des Kontaktabschnittes in den Lottiegel und damit eine Verbesserung der Lötqualität erreicht werden.

Vorteilhaft ist es, den wenigstens einen Verbindungssteg durch Tiefziehen zu biegen. Dadurch wird einerseits gewährleistet, daß der Kontaktabschnitt in eine definierte Stellung gebogen wird, und anderseits erreicht, daß die durch das Tiefziehen bedingte Verjüngung des Wärmeleitungsquerschnitts des wenigstens einen Verbindungssteges die Wirkung desselben als schlechten Wärmeableiter noch verstärkt.

Vorteilhaft ist weiterhin, wenn der an der Innenwandung der Ausnehmung angeordnete Abschnitt des metallischen Leiters wenigstens teilweise von der Umhüllung mit Isolierstoff ausgenommen ist. Hierdurch wird erreicht, daß die über die Verbindungsstege abfließende Wärme nicht unmittelbar mit den in den Isolierstoff eingebrachten Abschnitten der Leiterstruktur in Kontakt gelangt.

Eine besonders einfache Ausgestaltung der Erfindung sieht vor, daß der an der Innenwandung der Ausnehmung angeordnete Abschnitt kreisringförmig ausgebildet ist, daß der Kontaktabschnitt konzentrisch zu dem an der Innenwandung angeordneten Abschnitt angeordnet ist und daß der wenigstens eine verbindungssteg den kreisringförmigen Abschnitt in radialer Richtung mit dem Kontaktabschnitt verbindet.

### Zeichnungen

Ausführungsbeispiele der Erfindung sind in den Zeichnungen dargestellt und werden in der nachfolgenden Beschreibung erläutert. Es zeigt
Fig. 1 einen Querschnitt durch einen erfindungsgemäßen Baugruppenträger am Ort eines Kontaktbereichs während der Verlötung eines Bauelementes,
Fig. 2a und 2b eine Draufsicht und Seitenansicht eines der Leiter der Leiterstruktur mit Kontaktabschnitt und Verbindungsstegen,
Fig. 3 den erfindungsgemäßen Baugruppenträger mit darauf angebrachten Bauelementen,
Fig. 4 weitere Ausführungsbeispiele für die Ausbildung des Kontaktbereichs eines Baugruppenträgers.

### Beschreibung eines Ausführungsbeispiels

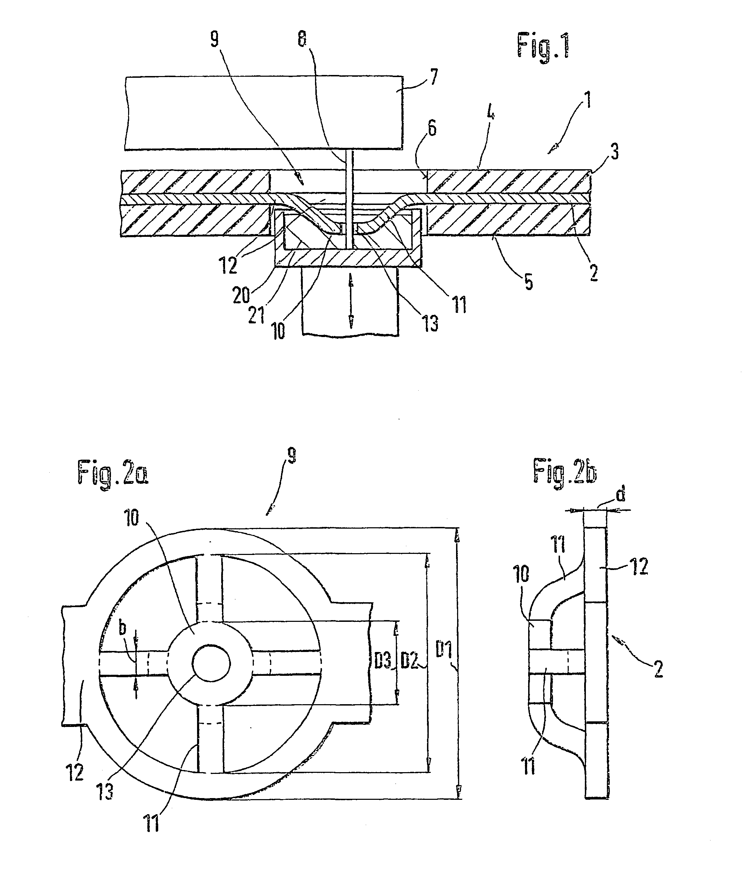

Fig. 1 zeigt einen Baugruppenträger 1, welcher eine aus einem im wesentlichen ebenen Stanzgitter gebildete Leiterstruktur aus mehreren metallischen Leitern 2 umfaßt. Die Leiterstruktur wird durch Stanzen eines dünnen Metallblechs mit einer Dicke von beispielsweise 1,2 mm hergestellt. Durch Umspritzen mit einem thermoplastischen Kunststoff sind die Leiter 2 in etwa mittig in eine Isolierstoffumhüllung 3 eingebettet, wobei Kontaktbereiche 9 der Leiter 2 von der Umhüllung mit Kunststoff ausgenommen sind. Der Baugruppenträger 1 ist plattenförmig mit einer Oberseite 4 und einer Unterseite 5 ausgebildet. In der Querschnittsdarstellung von Fig. 1 ist einer der Leiter 2 erkennbar. Eine von der Oberseite 4 zur Unterseite 5 durchgehende Ausnehmungen 6 in der Isolierstoffumhüllung 3 ermöglicht einen Zugang zu einem Kontaktabschnitt 10 des Leiters 2, welcher Kontaktabschnitt vollständig in der Ausnehmung 6 angeordnet ist und nur über schmale Verbindungsstege 11 mit einem an der Innenwandung der Ausnehmung 6 angeordneten Abschnitt 12 des Leiters 2 verbunden ist. Wie in Fig. 2a gezeigt, ist in dem hier gezeigten Ausführungsbeispiel der an der Innenwandung der Ausnehmung 6 angeordnete Abschnitt 12 kreisringförmig mit einem Außendurchmesser D1 von beispielsweise 9,4 mm und einem Innendurchmesser D2 von 7,6 mm ausgebildet. Der Kontaktabschnitt wird durch ein konzentrisch zu dem Abschnitt 12 angeordnetes Lötauge 10 mit einem Außendurchmesser D3 von beispielsweise 2,9 mm gebildet. Das Lötauge 10 ist über vier in radialer Richtung von dem Lötauge abstehende Verbindungsstege 11 mit einer Breite b von beispielsweise 0,9 mm mit dem kreisringförmigen Abschnitt 12 verbunden.

Wie weiterhin in Fig. 1 und Fig. 2b dargestellt ist, sind die Verbindungsstege 11 durch Tiefziehen derart abgebogen, daß sich der Kontaktabschnitt 10 innerhalb der kreisförmigen Ausnehmung 6 in einer zur Ebene der Leiterstruktur 2 parallelen Ebene an der Unterseite 5 des Baugruppenträgers befindet. Es ist aber auch möglich, die Verbindungsstege 11 soweit abzubiegen, daß sich der Kontaktabschnitt 10 beispielsweise unterhalb der Unterseite 5 des Baugruppenträgers 1 und außerhalb der Ausnehmung 6 befindet. Beim selektiven Verlöten des Kontaktabschnittes 10 mit einem Anschlußelement 8 eines elektrischen und/oder elektronischen Bauelementes 7 wird zunächst das Anschlußelement in eine Öffnung 13 des Kontaktabschnittes 10 eingesteckt und anschließend ein mit Lot 21 gefüllter Lottiegel 20 in die Ausnehmung 6 eingeführt. Durch die Biegung der Verbindungsstege 11 des Leiters 2 kann der Kontaktabschnitt 10 vollständig in das erhitzte und verflüssigte Lot 21 eintauchen, wodurch eine verbesserte Verlötung des Anschlußelementes 8 mit dem Kontaktabschnitt 10 erreicht wird. Falls der Kontaktabschnitt 10 von der Unterseite 5 des Baugruppenträgers absteht ist in diesem Fall auch eine Wellenlötung der Kontaktabschnitte 10 denkbar.

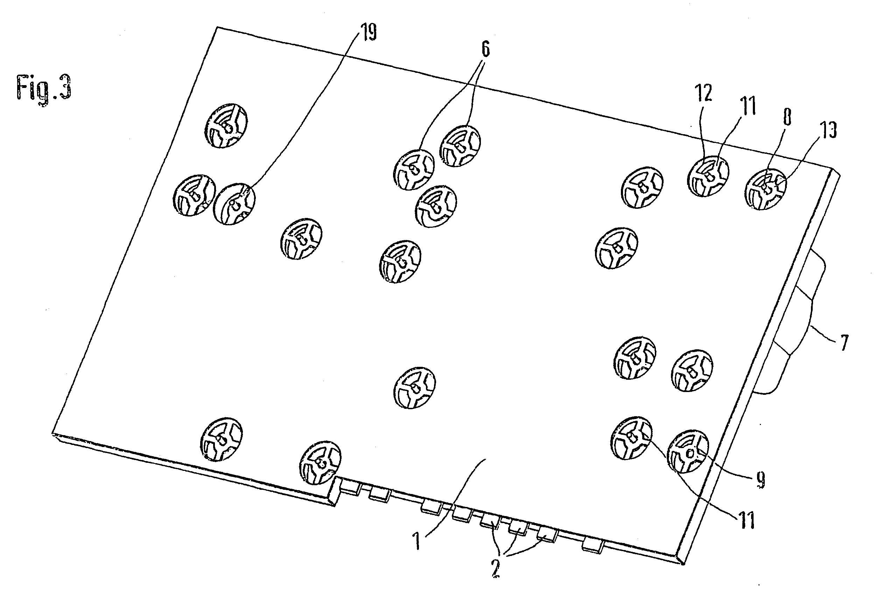

Die beim Verlöten auf den Kontaktabschnitt 10 übertragene Wärme fließt teilweise auf die Verbindungsstege 11 ab. Da diese nur einen kleinen Wärmeleitungsquerschnitt aufweisen, bewirken die Verbindungsstege 11 eine Drosselung des Wärmeabflusses auf den Abschnitt 12 des metallischen Leiters 2. Eine gute Wärmedrosselung und eine gute elektrischer Leitfähigkeit eines verbindungssteges 11 wird bei einem Stanzgitter mit einer Dicke d erreicht, falls der Wärmeleitungsquerschnitt Q des Verbindungssteges 11 in etwa der Bedingung d² < Q < 4 d² genügt. Diese Werte sind nur als Richtwerte anzusehen. In jedem Fall ist der Wärmeleitungsquerschnitt des Verbindungssteges 11 jedoch deutlich kleiner auszubilden als der Wärmeleitungsquerschnitt des mit dem übrigen Abschnitten des metallischen Leiters 2 verbundenen, an der Ausnehmung 6 angeordneten Abschnitts 12. Nur so wird eine ausreichende Drosselung der Wärmeabgabe an die im Isolierstoff eingebetteten Abschnitte des Leiters 2 erreicht. Der Kontaktbereich 9 wirkt dann quasi als "Wärmefalle". Der Abschnitt 12 ist wie in Fig. 1 und Fig. 3 erkennbar nur teilweise in Isolierstoff eingebettet. Der innere Teil des kreisringförmigen Abschnitts 12 ist dagegen von der Umhüllung mit Isolierstoff ausgespart. Durch diese Maßnahmen wird erreicht, daß die von den Verbindungsstegen abfließende Wärme nicht unmittelbar mit dem Kunststoff 3 in Kontakt gelangt.

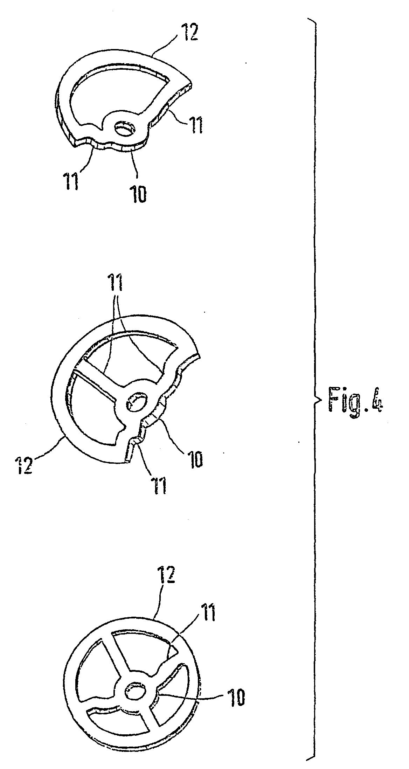

In anderen Ausführungsbeispielen kann vorgesehen sein, die Anzahl der Verbindungsstege 11 zu verringern oder zu vergrößern. So ist zum Beispiel in Fig. 3 ein Ausführungsbeispiel eines erfindungsgemäßen Baugruppenträgers dargestellt, bei dem Kontaktbereiche 19 vorgesehen sind, die nur drei Verbindungsstege 11 umfassen, die mit einem halbkreisförmigen Abschnitt 12 an der Innenwandung der Ausnehmung 6 verbunden sind. Aber auch andere Ausführungen mit nur zwei, einem oder mehr als vier Verbindungsstegen sind denkbar. In Fig. 4 sind einige mögliche Ausführungsbeispiele dargestellt. Die mit dem Abschnitt 12 einstückig verbundenen restlichen Abschnitte der Leiter 2 sind der Einfachheit halber nicht dargestellt. Es ist auch möglich, die Abschnitte 11, 10 und 12 als separates Teil zu fertigen und dieses in der Aussparung 6 mit den Leitern 2 zu kontaktieren.

## Patentansprüche

1. Baugruppenträger (1) für elektrische/elektronische Bauelemente (7), umfassend eine im wesentlichen ebene Leiterstruktur mit mehreren aus einem Stanzgitter gebildeten metallischen Leitern (2) und eine Isolierstoffumhüllung (3), in welche die metallischen Leiter (2) zumindest teilweise eingebettet sind,
wobei wenigstens ein zur Kontaktierung eines Anschlußelementes (8) eines elektrischen/elektronischen Bauelementes (7) vorgesehener Kontaktabschnitt (10) des metallischen Leiters (2) in einer durchgehenden Ausnehmung (6) der Isolierstoffumhüllung (3) angeordnet ist,
wobei der wenigstens eine Kontaktabschnitt (10) ausschließlich über wenigstens einen in der Ausnehmung (6) angeordneten Verbindungssteg (11) mit einem an der Innenwandung der Ausnehmung (6) angeordneten Abschnitt (12) des metallischen Leiters (2) leitend verbunden ist,
wobei der Wärmeleitungsquerschnitt des wenigstens einen Verbindungssteges (11) derartig klein ausgebildet ist, daß der Verbindungssteg (11) bei einer starken Erwärmung des Kontaktabschnittes (10) eine Drosselung des Wärmeabflusses auf den an der Innenwandung der Ausnehmung (6) angeordneten, einen größeren Wärmeleitungsquerschnitt aufweisenden Abschnitt (12) des Leiters (2) bewirkt, so daß eine Beschädigung der Isolierstoffumhüllung verhindert wird,
**dadurch gekennzeichnet,**
**daß** der wenigstens eine Verbindungssteg (11) aus der Ebene der Leiterstruktur derart abgebogen ist, daß der damit verbundene Kontaktabschnitt (10) in einer zur Ebene der Leiterstruktur parallelen Ebene innerhalb oder außerhalb der Ausnehmung (6) angeordnet ist.

2. Baugruppenträger nach Anspruch 1, **dadurch gekennzeichnet, daß** der Kontaktabschnitt (10) in Form eines Lötauges mit einer zentralen Öffnung (13) zur Durchführung eines Anschlußelementes (8) eines elektrischen/elektronischen Bauelementes (7) ausgebildet ist.

3. Baugruppenträger nach Anspruch 1, **dadurch gekennzeichnet, daß** der Verbindungssteg (11) durch Tiefziehen abgebogen ist.

4. Baugruppenträger nach Anspruch 1, **dadurch gekennzeichnet, daß** der an der Innenwandung der Ausnehmung (6) angeordnete Abschnitt (12) des metallischen Leiters (2) wenigstens teilweise von der Umhüllung mit Isolierstoff ausgenommen ist.

5. Baugruppenträger nach einem der vorstehenden Ansprüche, **dadurch gekennzeichnet, daß** der an der Innenwandung der Ausnehmung (6) angeordnete Abschnitt (12) kreisringförmig ausgebildet ist, daß der Kontaktabschnitt (10) konzentrisch zu dem an der Innenwandung (12) angeordneten Abschnitt (12) angeordnet ist und daß der wenigstens eine Verbindungssteg (11) den kreisringförmigen Abschnitt (12) in radialer Richtung mit dem Kontaktabschnitt (10) verbindet.

6. Baugruppenträger nach Anspruch 3, **dadurch gekennzeichnet, daß** durch das Tiefziehen eine Verjüngung des Wärmeleitungsquerschnitts des wenigstens einen Verbindungssteges (11) bewirkt wird.

## Claims

1. Mounting rack (1) for electrical/electronic components (7), comprising a substantially planar conductor structure with a number of metallic conductors (2), formed by a leadframe, and an insulating encapsulation (3), in which the metallic conductors (2) are at least partly embedded,
at least one contact portion (10) of the metallic conductor (2), provided for the contacting of a terminal element (8) of an electrical/electronic component (7), being arranged in a clearance (6) passing through the insulating encapsulation (3),
the at least one contact portion (10) being connected in a conducting manner to a portion (12) of the metallic conductor (2) arranged on the inner wall of the clearance (6), exclusively via at least one connecting web (11) arranged in the clearance (6),
the heat-conducting cross section of the at least one connecting web (11) being made small enough that, when there is intense heating of the contact portion (10), the connecting web (11) causes a restriction of the outflow of heat to the portion (12) of the conductor (2) that is arranged on the inner wall of the clearance (6) and has a larger heat-conducting cross section, so that damage to the insulating encapsulation is prevented,
**characterized**
**in that** the at least one connecting web (11) is bent away out of the plane of the conductor structure in such a way that the contact portion (10) connected to it is arranged in a plane parallel to the plane of the conductor structure inside or outside the clearance (6).

2. Mounting rack according to Claim 1, **characterized**
**in that** the contact portion (10) takes the form of a soldering eye with a central opening (13) for leading through a terminal element (8) of an electrical/electronic component (7).

3. Mounting rack according to Claim 1, **characterized**
**in that** the connecting web (11) is bent away by deep-drawing.

4. Mounting rack according to Claim 1, **characterized**
**in that** the portion (12) of the metallic conductor (2) that is arranged on the inner wall of the clearance (6) is at least partly omitted from the encapsulation with insulating material.

5. Mounting rack according to one of the preceding claims, **characterized in that** the portion (12) arranged on the inner wall of the clearance (6) is formed in an annular manner, **in that** the contact portion (10) is arranged concentrically in relation to the portion (12) arranged on the inner wall (12) and **in that** the at least one connecting web (11) connects the annular portion (12) to the contact portion (10) in the radial direction.

6. Mounting rack according to Claim 3, **characterized**
**in that** a tapering of the heat-conducting cross section of the at least one connecting web (11) is brought about by the deep-drawing.

## Revendications

1. Support modulaire (1) pour composants électriques/électroniques (7), comprenant une structure conductrice pour l'essentiel plane dotée de plusieurs conducteurs métalliques (2) formés à partir d'une grille emboutie, et un enrobage de matière isolante (3) dans lequel les conducteurs métalliques (2) sont au moins en partie insérés, pour lequel
- au moins une partie de contact (10) du conducteur métallique (2), prévue pour le contact d'un élément de connexion (8) d'un composant électrique/électronique (7), est disposée dans un évidement traversant (6) présent dans l'enrobage de matière isolante (3),
- la au moins une partie de contact (10) est reliée de façon conductrice, exclusivement par le biais d'une traverse de raccordement (11) disposée dans l'évidement (6), à un segment (12) du conducteur métallique (2) appliqué contre la paroi intérieure de l'évidement (6), et
- la section transversale conductrice de chaleur de la au moins une traverse de raccordement (11) est configurée pour être de petite taille, de telle sorte que la traverse de raccordement (11) provoque, lors d'un fort réchauffement de la partie de contact (10), un étranglement de l'écoulement de chaleur sur le segment (12) du conducteur (2) appliqué contre la paroi intérieure de l'évidement (6), qui présente une section transversale conductrice de chaleur plus grande, de telle sorte que l'on évite ainsi un endommagement de l'enrobage de matière isolante,
**caractérisé en ce que**
la au moins une traverse de raccordement (11) est pliée hors du plan de la structure conductrice, de telle sorte que la partie de contact (10) qui y est reliée est disposée dans un plan parallèle au plan de la structure conductrice, à l'intérieur ou à l'extérieur de l'évidement (6).

2. Support modulaire selon la revendication 1,
**caractérisé en ce que**
la partie de contact (10) est configurée sous la forme d'une pastille comportant un orifice central (13) permettant de faire passer un élément de connexion (8) d'un composant électrique/électronique (7).

3. Support modulaire selon la revendication 1,
**caractérisé en ce que**
la traverse de raccordement (11) est pliée par emboutissage.

4. Support modulaire selon la revendication 1,
**caractérisé en ce que**
le segment (12) du conducteur métallique (2) appliqué contre la paroi intérieure l'évidement (6) est au moins en partie exempte de l'enrobage de matière isolante.

5. Support modulaire selon l'une des revendications précédentes,
**caractérisé en ce que**
le segment (12) appliqué contre la paroi intérieure de l'évidement (6) est configuré sous la forme d'une couronne, la partie de contact (10) est disposée de façon concentrique par rapport au segment (12) appliqué contre la paroi intérieure, et la au moins une traverse de raccordement (11) relie le segment (12) en forme de couronne avec la partie de contact (10), en direction radiale.

6. Support modulaire selon la revendication 3,
**caractérisé en ce que**
l'emboutissage conduit à un rétrécissement de la section transversale conductrice de chaleur de la au moins une traverse de raccordement (11).
